# EUROPÄISCHE PATENTSCHRIFT

(11) **EP 0 987 742 B1**
(45) Veröffentlichungstag und Bekanntmachung des Hinweises auf die Patenterteilung: **30.05.2007**
(21) Anmeldenummer: 99118448.2
(22) Anmeldetag: 17.09.1999
(51) Int. Cl.: H01L 21/8239, H01L 21/329, H01L 21/225, H01L 21/321, H01L 21/3105

(54) **Verfahren zum Herstellen eines Dotierungsgebietes mittels Diffusion in einer Speicherzellenanordnung**
Process for forming a doped region through diffusion in a memory structure
Méthode de formation d'une région dopée par diffusion dans une structure de mémoire

(30) Priorität: 18.09.1998 DE 19842882
(43) Veröffentlichungstag der Anmeldung: 22.03.2000
(73) Patentinhaber: Infineon Technologies AG, 81669 München (DE)
(72) Erfinder: Reisinger, Hans, Dr., 82031 Grünwald (DE); Stengl, Reinhard, Dr., 86391 Stadtbergen (DE); Franosch, Martin, 81739 München (DE); Lehmann, Volker, Dr., 80689 München (DE); Schäfer, Herbert, Dr., 85635 Höhenkirchen-Siegertsbrunn (DE); Lange, Gerrit, Dr., 81373 München (DE); Wendt, Hermann, Dr., 85630 Grasbrunn (DE)
(74) Vertreter: Kindermann, Peter

(56) Entgegenhaltungen:
- US-A- 5 279 976
- US-A- 5 416 343
- WU S L ET AL: "IMPROVEMENT OF ELECTRICAL CHARACTERISTICS OF POLYCRYSTALLINE SILICON-CONTACTED DIODES AFTER FORWARD BIAS STRESSING" APPLIED PHYSICS LETTERS, AMERICAN INSTITUTE OF PHYSICS. NEW YORK, US, Bd. 57, Nr. 18, 29. Oktober 1990 (1990-10-29), Seiten 1904-1906, XP000172654 ISSN: 0003-6951

## Beschreibung

Bei der Herstellung von integrierten Schaltungen werden eine Vielzahl von Bauelementen in einem Halbleitersubstrat gebildet. Typischerweise erfolgt dies durch bereichsweise Dotierung des Halbleitermaterials, das in der Regel einen Leitungstyp aufweist. Durch eine Vielzahl derartiger und Dotierungschritte werden z.B. MOS-Transistoren oder Dioden hergestellt. Dabei müssen oftmals Masken zum Abdecken von nicht zu dotierende Bereichen verwendet werden, die zu einer Erhöhung der Prozeßschrittzahl führen. Bei einem nachträglichen Kontaktieren der geschaffenen Dotierungsgebiete sind weitere Masken nötig.

Eine Möglichkeit, Dotierungsgebiete zu schaffen, ist beispielsweise in der EP 0 480 178 a2 beschrieben. Dort wird auf einem Siliziumsubstrat ein sogenanntes Tunnel-Oxid augebracht und auf dieses eine Polysiliziumschicht abgeschieden, die nachfolgend geeignet dotiert wird. Unter Einwirkung von hohen Temperaturen gelangen anschließend die in die Polysiliziumschicht implantierten Dotierstoffe durch Diffusion durch das Tunnel-Oxid hindurch in das Siliziumsubstrat und bilden dort ein Dotierungsgebiet. Eine Kontaktierung des Dotiergebiets ist nicht vorgesehen.

Aus dem Artikel "Improvement of electrical characteristics of polycrystalline silicon- contacted diodes after forward bias stressing", S. L. Wu u.a., Appl. Phys. Lett. 57 (18), 29. Oktober 1990, Seiten 1904 - 1906 ist im Zusammenhang mit Dioden, die durch Polysilizium kontaktiert werden ein Experiment bekannt, bei dem an einem Polysilizium/Monosilizium Interface mit einer Siliziumoxidschicht nach dem Anlegen einer Sperrspannungsrampe eine metallurgische Übergangsveränderung auftritt. Die Sperrspannung überschreitet die Durchbruchsspannung und es wird angenommen, dass ein lokales Aufschmelzen während des Anlegens der Sperrspannungsrampe auftritt.

Aus der US-Patentschrift 5,416,343 ist eine nichtflüchtige Speicheranordnung bekannt, bei der Daten durch das gleichzeitige Durchbrechen einer Siliziumoxidschicht in Verbindung mit dem Herstellen einer Diode mit "vergleichsweise guten" Eigenschaften eingeschrieben werden. Die US-Patentschrift 5,279,976 betrifft die Herstellung eines Bipolartransistors.

Es ist daher Aufgabe der Erfindung, ein Verfahren zum Herstellen eines Dotierungsgebiets vorzuschlagen, das die oberen Nachteile umgeht.

Diese Aufgabe wird erfindungsgemäß durch ein Verfahren gemäß Patentanspruch 1 mit folgenden Schritten gelöst:
- Bereitstellen eines Halbleitersubstrats, das eine Oberfläche aufweist;
- Aufbringen einer elektrisch isolierenden Zwischenschicht auf die Oberfläche;
- Aufbringen einer dotierten Halbleiterschicht auf die elektrisch isolierende Zwischenschicht, wobei die Halbleiterschicht einen ersten Leitungstyp aufweist und einen Dotierstoff vom ersten Leitungstyp enthält;
- Temperieren des Halbleitersubstrats bei einer vorgegebenen Diffusionstemperatur, so daß der Dotierstoff teilweise aus der Halbleiterschicht durch die Zwischenschicht hindurch in das Halbleitersubstrat diffundiert und dort zumindest ein Dotierungsgebiet vom ersten Leitungstyp bildet; und danach,
- Verändern der elektrischen Leitfähigkeit der Zwischenschicht, so daß durch die Zwischenschicht hindurch ein elektrischer Kontakt zwischen dem Dotierungsgebiet und der Halbleiterschicht entsteht.

Ein wesentlicher Gedanke der Erfindung ist, daß das Dotierungsgebiet selbstjustiert im Halbleitersubstrat ausgebildet wird. Dazu wird ein Halbleitersubstrat, an dem eine Halbleiterschicht vom ersten Leitungstyp angeordnet ist, einem Temperaturschritt unterzogen. Die in dieser Halbleiterschicht enthaltenen Dotierstoffe vom ersten Leitungstyp diffundieren bei dem Temperaturschritt durch die Zwischenschicht hindurch in das Halbleitersubstrat und bilden dort zumindest ein Dotierungsgebiet vom ersten Leitungstyp. Die Temperierung, bzw. der Diffusionsschritt, wird dabei über eine vorbestimmte Zeitdauer und bei einer vorgegebenen Diffusionstemperatur durchgeführt. Die Zeitdauer und die Diffusionstemperatur sind dabei bevorzugt so aufeinander abgestimmt, daß sich das Dotierungsgebiet bis zu einer gewünschten Tiefe im Halbleitersubstrat ausbildet. Durch eine nachfolgende Veränderung der elektrischen Leitfähigkeit der Zwischenschicht wird abschließend eine Kontaktierung des Dotierungsgebiets erreicht. Es entsteht somit durch die anfänglich noch isolierende Zwischenschicht hindurch ein elektrischer Kontakt zwischen dem Dotierungsgebiet und der Halbleiterschicht. Sofern das Halbleitersubstrat vom gleichen Dotierungstyp wie das Dotierungsgebiet ist, wird durch Kontaktierung des Dotierungsgebiets gleichzeitig auch das Halbleitersubstrat in vorteilhafter Weise kontaktiert.

Die Veränderung der Leitfähigkeit der Zwischenschicht läßt sich durch Einwirken eines elektrischen Feldes bewirken. Dazu wird über der Zwischenschicht ein elektrisches Feld ausreichender Stärke aufgebaut, durch das ein elektrischer Durchbruch der Zwischenschicht erreicht wird.

Ein Vorteil dieser Erfindung ist, daß eine Kontaktierung des Doetierungsgebiets bzw. des Halbleitersubstrats selektiv an dafür vorgesehenen Bereichen erfolgen kann. Ein zusätzlicher Ätzschritt zum Definieren von Kontaktbereichen entfällt.

Sofern das Halbleitersubstrat selbst einen Leitungstyp, beispielsweise einen gegenüber dem ersten Leitungstyp entgegengesetzten zweiten Leitungstyp aufweist, entsteht mit der Bildung des Dotierungsgebiets ein unmittelbarer Übergang zwischen den beiden Leitungstypen im Halbleitersubstrat, der als Diodenübergang einen Stromfluß unidirektional sperrt.

Bevorzugt besteht die Zwischenschicht aus einem Oxid, wobei das Oxid durch einen geeigneten Stromimpuls von seinem isolierenden Zustand in einen leitfähigen Zustand überführt werden kann. Die Diffusionstemperatur, bei der die Temperaturbehandlung des Halbleitersubstrats durchgeführt wird, liegt oberhalb von 600° C, bevorzugt oberhalb von 800° C. Je höher die Diffusionstemperatur, desto schneller bildet sich das Dotierungsgebiet heraus. Besonders günstig ist eine Diffusionstemperatur bei etwa 1000° C.

Das Verfahren eignet sich somit allgemein zur Bildung von Dotierungsgebieten in einem Halbleitersubstrat. Ein Vorteil der Erfindung ist, daß sich das Dotierungsgebiet selbstjustiert bezüglich der Halbleiterschicht ausbildet. Zusätzliche Maskenschritte sind nicht nötig.

Es ist vorteilhaft, die Halbleiterschicht vor dem Temperieren geeignet zu strukturieren. Dadurch bildet sich einerseits das Dotierungsgebiet nur in vorgegebenen Bereichen im Halbleitersubstrat aus. Andererseits kann die Halbleiterschicht in Form von Leiterbahnen oder Adreßleitungen geeignet strukturiert werden. Im Ergebnis entsteht eine Struktur, bei der an vorbestimmten Bereichen kontaktierte Dotierungsgebiete vorgesehen sind.

Bevorzugt kann die Halbleiterschicht auch gleichzeitig zum Kontaktieren des Dotierungsgebiets verwendet werden. Dazu ist es notwendig, die Zwischenschicht in einen leitfähigen Zustand zu überführen. Insbesondere bei Halbleiterschichten aus Oxiden kann dies durch einen gezielten Stromstoß erfolgen. Dabei bilden sich leitfähige Pfade in dem Oxid heraus, über die der elektrische Kontakt zwischen der Halbleiterschicht und dem Dotierungsgebiet hergestellt wird.

Oxide, beispielsweise Gate-Oxide, weisen relativ definierte Durchbruchsspannungen auf, so daß durch Applizieren einer geeignet dimensionierten Spannung die Zwischenschicht leitfähig gemacht werden kann. Die Höhe der applizierten Spannung bzw. der auf die Zwischenschicht wirkenden elektrischen Feldstärke hängt unter anderem von der Dicke der Zwischenschicht ab. Um übermäßig hohe Spannungen und damit hohe Verlustleistungen zu vermeiden, empfiehlt es sich, die Zwischenschicht ausreichend dünn auszubilden. Ein bevorzugtes Oxid ist beispielsweise Siliziumoxid (SiO₂). Bei intaktem Oxid fällt die angelegte Spannung im wesentlichen über dem intaktem Oxid ab. Im Gegensatz dazu sollte bei elektrisch durchbrochenem Oxid dessen Widerstand einen deutlich geringeren Wert aufweisen und einen guten ohmschen Kontakt zwischen dem Dotierungsgebiet und der Halbleiterschicht vermitteln. Beträgt beispielsweise der spezifische Widerstand des verwendeten Oxids 10¹² Ω/cm, so weist ein 10 nm dickes Oxid einen Widerstand von 10⁶ Ω auf.

Als vorteilhaft hat es sich erwiesen, die Halbleiterschicht aus in situ dotiertem Polysilizium mit einem Dotierstoffgehalt zwischen 10²⁰/cm³ und 10²²/cm³ herzustellen. Als Dotierstoffe werden beispielsweise Arsen beziehungsweise Phosphor zur n-Dotierung verwendet. Selbstverständlich kann die Halbleiterschicht auch eine p-Dotierung aufweisen.

Der hohe Dotierstoffgehalt sichert einerseits eine gute Leitfähigkeit des Polysiliziums. Andererseits steht durch den hohen Dotierstoffgehalt in der Halbleiterschicht ein großes Reservoir an Dotierstoffen zur Verfügung, das zur Ausbildung des Dotierungsgebiets verwendet wird. Die in der Halbleiterschicht enthaltenen Dotierstoffe diffundieren, beispielsweise aktiviert durch den thermischen Prozeß, bis zu einem gewissen Grade in das Halbleitersubstrat und bilden dort das Dotierungsgebiet.

Günstig ist es, die Temperierung bei Temperaturen oberhalb von 800°C, bevorzugt bei 1000°C durchzuführen.

Im folgenden wird die Erfindung anhand eines Ausführungsbeispiels erläutert und schematisch in Figuren dargestellt. Es zeigen:

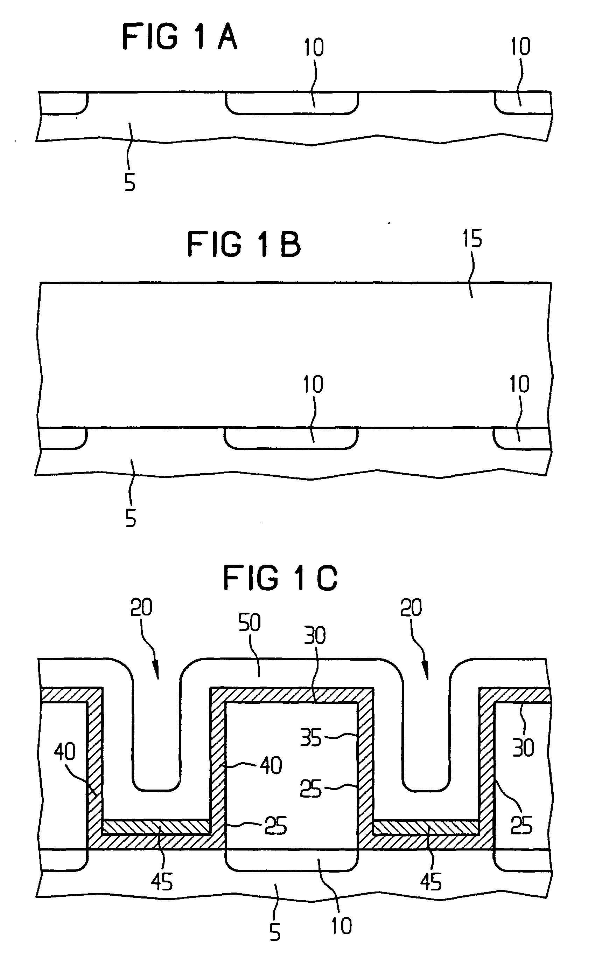

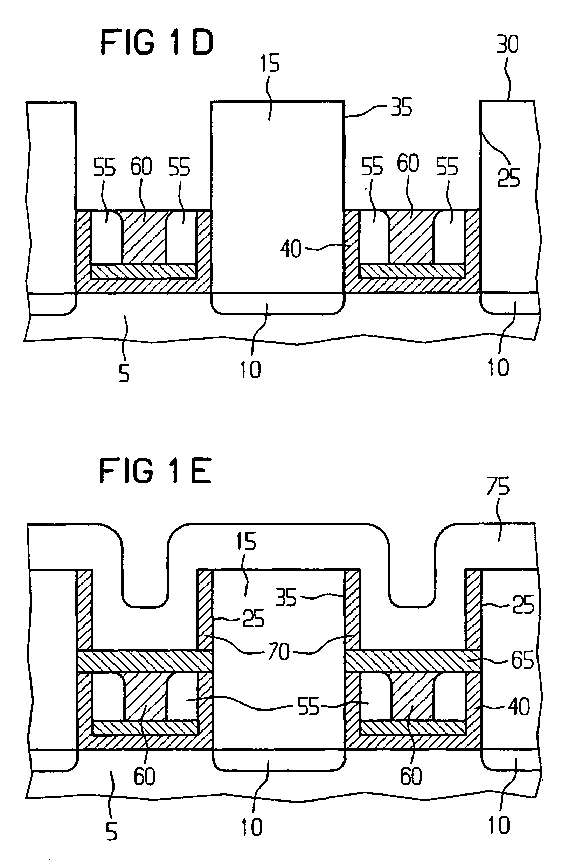

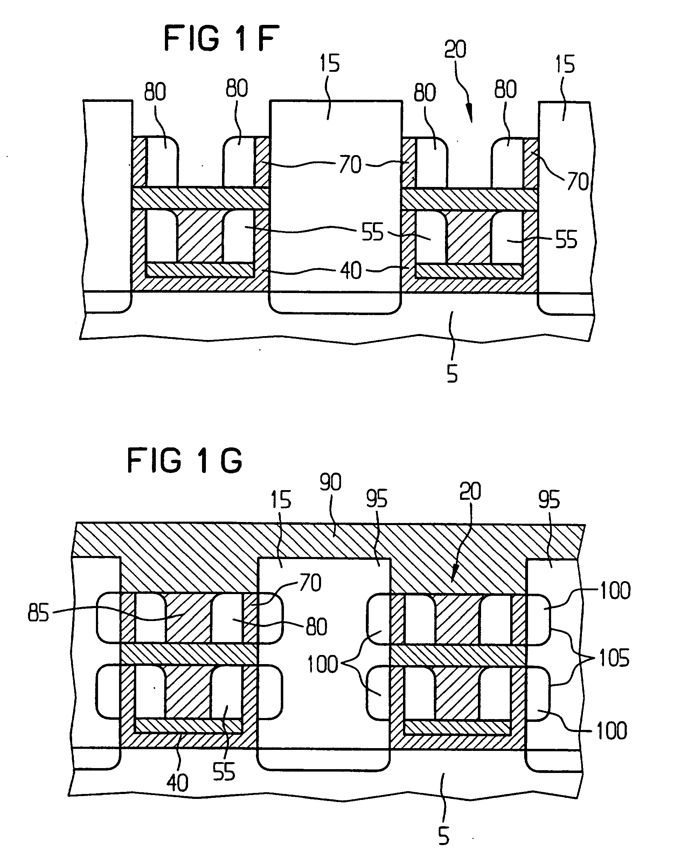

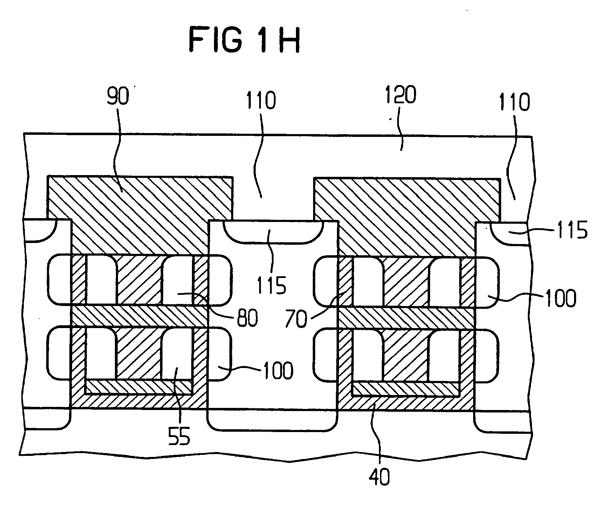

Figuren 1a bis 1h Verfahrensschritte zur Herstellung von Dotierungsgebieten.

Das erfindungsgemäße Verfahren soll anhand der Herstellung einer Dotierungsgebiets in einer Speicherzellenanordnung beschrieben werden. Zur Herstellung einer derartigen Speicherzellenanordnung wird zunächst ein Grundsubstrat 5 mit bereits integrierten Isolationsgebieten 10 bereitgestellt. Diese Isolationsgebiete 10 sind in ihrer Größe und ihrem seitlichen Abstand einer nachfolgend zu bildenden Struktur angepaßt.

Anschließend wird ein bereist dotiertes Halbleitersubstrat 15, bevorzugt Silizium, epitaktisch auf das Grundsubstrat 5 abgeschieden. Danach erfolgt mittels geeigneter Maskentechnik das Einätzen von Gräben 20 in das Halbleitersubstrat 15. Die Seitenwände 25 sowie die Oberseite 30 der Gräben 20 stellen im folgenden die Oberfläche 35 des Halbleitersubstrats 15 dar. Auf diese Oberfläche 35 wird nun eine konforme und elektrisch isolierende Zwischenschicht 40 aufgebracht. Gegebenenfalls erfolgt nach diesem Schritt ein Abscheiden eines CVD-Oxids 45, bevorzugt TEOS, im unteren Bereich der Gräben 30.

Die elektrisch isolierende Zwischenschicht 40 besteht bevorzugt aus Siliziumdioxid (SiO₂) und wird mittels eines CVD-Prozesses auf die Oberfläche in einer Materialstärke zwischen 3 und 20 nm, bevorzugt zwischen 4 und 10 nm aufgetragen.

Daran schließt sich das konforme Auftragen einer dotierten Halbleiterschicht 50 auf die Zwischenschicht 40 an, wobei die dotierte Halbleiterschicht 50 durch eine in situ dotierte Polysiliziumschicht 50 mit einer Dotierstoffkonzentration von etwa 10²⁰/cm³ bis 10²²/cm³ gebildet wird. Die Polysiliziumschicht 50 weist gegenüber dem Leitfähigkeitstyp des Halbleitersubstrats 15 einen entgegengesetzten Leitfähigkeitstyp auf. Die erhaltene Struktur ist in Figur 1c dargestellt. Anschließend werden die Polysiliziumschicht 50 und die Zwischenschicht 40 bis etwa zur halben Höhe der Gräben 20 anisotrop zurückgeätzt. Dadurch entstehen an den Seitenwänden 25 jedes Grabens 20 erste untere Adreßleitungen 55 sowie die zwischen den ersten unteren Adreßleitungen 55 und der Seitenwand 25 angeordnete Zwischenschicht 40. Die verbleibenden Hohlräume zwischen den ersten unteren Adreßleitungen 55 lassen sich mit einem thermischen Oxid 60 planarisieren. Nachfolgend wird, wie in Figur 1e dargestellt, zunächst ein weiteres Oxid 65 zum Bedecken der ersten unteren Adreßleitungen 55 und der Zwischenschicht 40 aufgetragen.

Jetzt schließt sich das selbstjustierte Ausbilden einer weiteren Zwischenschicht 70 an den Seitenwänden 25 im oberen Bereich des Grabens 20 an, auf der eine weitere Polysiliziumschicht 75 aufgetragen wird. Bevorzugt wird, wie in Figur 1e dargestellt, die Zwischenschicht 70 bereits vor dem Auftragen der weiteren Polysiliziumschicht 75 anisotrop geätzt.

Nach einem anisotropen Zurückätzen der Polysiliziumschicht 75 sind nun im oberen Teil des Grabens 20 erste obere Adreßleitungen 80 entstanden. Die erhaltene Struktur ist in Figur 1f dargestellt.

Die verbleibenden Hohlräume werden mit einem Oxid 85 sowie mit einer planaren isolierenden Schicht 90 aufgefüllt, wobei die isolierende Schicht 90 die Gräben 20 und die zwischen den Gräben 20 angeordneten Stege 95 vollständig bedeckt. Durch einen thermischen Ausheilschritt werden nun die in den ersten und zweiten Adreßleitungen 55 und 80 enthaltenen Dotierstoffe aktiviert und diffundieren dabei durch die Zwischenschichten 40 und 70 in das Halbleitersubstrat 15. Dabei entstehen die Dotierungsgebiete 100, die gegenüber dem Halbleitersubstrat 15 einen entgegengesetzten Leitfähigkeitstyp aufweisen. Der sich dabei herausbildende unmittelbare Übergang 105 zwischen den Dotierungsgebieten 100 und den Halbleitersubstrat 15 wirkt als sperrender pn-Übergang. Zur Ausbildung der ersten Dotierungsgebiete 100 benötigt man bei einer etwa 4 nm dicken Zwischenschicht aus Siliziumoxid (SiO₂) bei 1000° C etwa 60 min. Weisen die ersten Adreßleitungen 55 und 80 beispielsweise eine Dotierstoffkonzentration zwischen 10²¹ und 10²²/cm³ auf, so beträgt bei obigen Prozeßparametern die Ausdehnung der Dotierungsgebiete 100 in das Halbleitersubstrat 15 hinein etwa 30 bis 50 nm, wobei als Grenze ein Abfall der Dotierstoffkonzentration um 3 Dekaden gegenüber der Dotierstoffkonzentration in den ersten Adreßleitungen 55 und 80 zugrunde gelegt wurde. Diese Messungen wurden mittels Secondary Ion Mass Spectroscopy verifiziert.

In einem abschließenden Verfahrensschritt werden zunächst Kontaktlöcher 110 in der isolierenden Schicht 90 gebildet. Durch diese hindurch kann das Halbleitersubstrat 15 an seiner Oberseite kontaktiert werden. Zum Bereitstellen eines möglichst widerstandsarmen Kontakts wird dazu das Halbleitersubstrat 15 an seiner Oberseite mit einem hochdotierten Kontaktgebiet 115, welches den gleichen Leitungstyp wie das Halbleitersubstrat 15 ausweist, versehen. Bevorzugt erfolgt die Bildung dieser Kontaktgebiete 115 mittels Ionenimplantation durch die Kontaktlöcher 110 hindurch. Dadurch werden keine weiteren Masken benötigt. Anschließend werden die Kontaktlöcher 110 mit einem leitfähigen Material befüllt. Bevorzugt werden dazu auf die isolierende Schicht 90 weitere Adreßleitungen 120 aufgebracht, die dabei gleichzeitig die Kontaktlöcher 110 füllen und so das Halbleitersubstrat 15 über die Kontaktgebiete 115 kontaktieren.

Die Zwischenschichten 40 bzw. 70 werden nachfolgend mittels elektrischem Durchbruch in ihrer Leitfähigkeit verändert. Dazu wird ein ausreichend bemessenes elektrisches Feld, z.B. durch Anlegen einer Spannung von 10 V, appliziert. Bei aus Siliziumoxid bestehenden Zwischenschichten 40 bzw. 70 mit einer Dicke von 10 nm (resultierende Feldstärke 10 MV/cm) fließt ein Strom von etwa 1 mA/cm². Dieser Stromfluß erhöht sich um jeweils eine Dekade pro 1 V. Damit ergibt sich bei 10 V eine Zeitdauer von etwa 1000 sec zum Durchbrennen der Zwischenschicht, oder von 1 msec bei 16 V. Gleichzeitig werden Daten in die Zwischenschichten 40 und eingespeichert. So repräsentiert beispielsweise eine isolierende Zwischenschicht eine logische 0, während ein elektrisch durchbrochenes und damit leitfähiges Oxid eine logische 1 repräsentiert.

Mittels des erfindungsgemäßen Verfahrens können auch einfache Kontakte hergestellt werden. So ist es möglich, daß hochdotierte Dotierungsgebiete, als ohmscher Kontakt zum Kontaktieren des Halbleitersubstrats dient. In diesem Fall weisen die Dotierungsgebiete und das Halbleitersubstrat den gleichen Leitungstyp auf.

## Patentansprüche

1. Verfahren zum Herstellen eines Dotierungsgebiets in einer Speicherzellenanordnung und zum Einspeichern von Daten mit folgenden Schritten:
- Bereitstellen eines Halbleitersubstrats (15), das eine Oberfläche (35) aufweist;
- Aufbringen einer elektrisch isolierenden Zwischenschicht (40, 70) auf die Oberfläche;
- Aufbringen einer dotierten Halbleiterschicht (50, 75) auf die elektrisch isolierende Zwischenschicht (40, 70), wobei die Halbleiterschicht (50, 75) einen ersten Leitungstyp aufweist und einen Dotierstoff vom ersten Leitungstyp enthält;
- Temperieren des Halbleitersubstrats (15) bei einer vorgegebenen Diffusionstemperatur, so daß der Dotierstoff teilweise aus der Halbleiterschicht (50, 75) durch die Zwischenschicht (40, 70) hindurch in das Halbleitersubstrat (15) diffundiert und dort zumindest ein Dotierungsgebiet (100) vom ersten Leitungstyp bildet; und danach,
- Verändern der elektrischen Leitfähigkeit der Zwischenschicht (40, 70) beim Einspeichern von Daten in die Zwischenschicht (40, 70) der Speicherzellenanordnung, so daß durch die Zwischenschicht (40, 70) hindurch ein elektrischer Kontakt zwischen dem Dotierungsgebiet (100) und der Halbleiterschicht (50, 70) entsteht, wobei die Leitfähigkeit der Zwischenschicht (40, 70) mittels eines Spannungs- oder eines Stromimpulses verändert wird.

2. Verfahren nach Anspruch 1, **dadurch gekennzeichnet, daß** die Zwischenschicht (40, 70) aus einem Oxid besteht.

3. Verfahren nach Anspruch 2, **dadurch gekennzeich-net, daß** das Oxid Siliziumoxid ist.

4. Verfahren nach einem der Ansprüche 1 bis 3, **dadurch gekennzeichnet, daß** die Halbleiterschicht (50, 75) aus in situ dotiertem Polysilizium mit einer Dotierstoffkonzentration von 10²⁰/cm³ bis 10²²/cm³ besteht.

5. Verfahren nach einem der vorhergehenden Ansprüche, **dadurch gekennzeichnet, daß** die Diffusionstemperatur oberhalb von 800°C liegt.

6. Verfahren nach einem der vorhergehenden Ansprüche, **dadurch gekennzeichnet , daß** das Halbleitersubstrat (15) einen zweiten Leitungstyp aufweist und dort durch die Bildung des Dotiergebiets (55, 80) ein Diodenübergang entsteht.

## Claims

1. Method for fabricating a dopant region in a memory cell array and for the purpose of storing data, having the following steps:
- preparation of a semiconductor substrate (15) which has a surface (35);
- application of an electrically insulating intermediate layer (40, 70) to the surface;
- application of a doped semiconductor layer (50, 75) to the electrically insulating intermediate layer (40, 70), the semiconductor layer (50, 75) being of a first conduction type and containing a dopant of the first conduction type;
- temperature treatment of the semiconductor substrate (15) at a predefined diffusion temperature, so that the dopant diffuses partially out of the semiconductor layer (50, 75) through the intermediate layer (40, 70) into the semiconductor substrate (15) and forms there at least one dopant region (100) of the first conduction type; and then
- modification of the electrical conductivity of the intermediate layer (40, 70) when storing data in the intermediate layer (40, 70) of the memory cell array, so that an electrical contact between the dopant region (100) and the semiconductor layer (50, 70) is produced through the intermediate layer (40, 70), the conductivity of the intermediate layer (40, 70) being modified by means of a voltage pulse or a current pulse.

2. Method according to Claim 1, **characterized in that** the intermediate layer (40, 70) is composed of an oxide.

3. Method according to Claim 2, **characterized in that** the oxide is silicon dioxide.

4. Method according to one of Claims 1 to 3, **characterized in that** the semiconductor layer (50, 75) is composed of polysilicon which is doped in situ with a dopant concentration of 1020/cm3 to 1022/cm3.

5. Method according to one of the preceding claims, **characterized in that** the diffusion temperature is above 800øC.

6. Method according to one of the preceding claims, **characterized in that** semiconductor substrate (15) is of a second conduction type and a diode junction is produced there by forming the dopant region (55, 80).

## Revendications

1. Procédé de production d'une zone de dopage dans un dispositif de cellules de mémoire et de mémorisation de données, comprenant des stades suivants :
- on se procure un substrat(15) semi-conducteur qui a une surface (35) ;
- on dépose une couche (40, 70) intermédiaire et isolante électriquement sur la surface ;
- on dépose une couche (50, 75)semi-conductride dopée sur la couche (40, 70) intermédiaire isolante électriquement, la couche (50, 75) semi-conductrice ayant un premier type de conductivité et contenant une substance de dopage du premier type de conductivité ;
- on traite thermiquement le substrat (15) semi-conducteur à une température de diffusion prescrite de sorte que la substance de dopage diffuse au moins en partie de la couche (50, 75) semi-conductrice dans le substrat (15) semi-conducteur en passant à travers la couche (40, 70) intermédiaire et y forme au moins une zone (100) de dopage du premier type de conductivité ; et ensuite
- on modifie la conductivité électrique de la couche (40, 70) intermédiaire lors de la mémorisation de données dans la couche (40, 70) intermédiaire du dispositif de cellules de mémoire de manière à créer à travers la couche (40, 70) intermédiaire un contact électrique entre la zone (100) de dopage et la couche (50, 70) semi-conductrice, la conductivité de la couche (40, 70) intermédiaire étant modifiée au moyen d'une impulsion de tension ou d'une impulsion de courant.

2. Procédé de production suivant la revendication 1, **caractérisé en ce que** la couche (40, 70) intermédiaire est en un oxyde.

3. Procédé de production n suivant la revendication 2, **caractérisé en ce que** l'oxyde et de l'oxyde de silicium.

4. Procédé de production suivant l'une des revendications 1 à 3, **caractérisé en ce que** la couche (50, 75) semi-conductrice est en polysilicium dopé in situ ayant une concentration de substance de dopage de 10²⁰ / cm³ à 10²² / cm³.

5. Procédé de production suivant l'une des revendications précédentes, **caractérisé en ce que** la température de diffusion est supérieure à 800° C.

6. Procédé de production suivant l'une des revendications précédentes, **caractérisé en ce que** le substrat (15) semi-conducteur a un deuxième type de conductivité et il y est formé une jonction de diode par la formation de la zone (55, 80) de dopage.
